(19) Europäisches Patentamt / European Patent Office / Office européen des brevets

(11) **EP 4 246 135 B1**

(12) **FASCICULE DE BREVET EUROPEEN**

(45) Date de publication et mention de la délivrance du brevet:
**11.12.2024 Bulletin 2024/50**

(21) Numéro de dépôt: **23162126.9**

(22) Date de dépôt: **15.03.2023**

(51) Classification Internationale des Brevets (IPC):
**G01N 23/201** (2018.01)    **G03F 7/20** (2006.01)

(52) Classification Coopérative des Brevets (CPC):
**G01N 23/201; G03F 7/70633**

(54) **PROCÉDÉ AMÉLIORÉ DE MESURE D'UN ÉCART D ALIGNEMENT PAR DIFFUSION DES RAYONS X AUX PETITS ANGLES PAR TRANSMISSION - T-SAXS ; SYSTÈME INSTRUMENTAL ET PRODUIT PROGRAMME D'ORDINATEUR ASSOCIÉS**

VERBESSERTES VERFAHREN ZUR MESSUNG DER AUSRICHTUNG EINES ZEILENABLENKUNGSFEHLERS IN KLEINEN WINKELN DURCH T-SAXS-ÜBERTRAGUNG ; ENTSPRECHENDES INSTRUMENTALSYSTEM UND COMPUTERPROGRAMMPRODUKT

IMPROVED METHOD FOR MEASURING A MISALIGNMENT USING SMALL ANGLE SCATTERING BY TRANSMISSION - T-SAXS; ASSOCIATED INSTRUMENTAL SYSTEM AND COMPUTER PROGRAM PRODUCT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **17.03.2022 FR 2202371**

(43) Date de publication de la demande:
**20.09.2023 Bulletin 2023/38**

(73) Titulaire: **Commissariat à l'Energie Atomique et aux Energies Alternatives**
**75015 Paris (FR)**

(72) Inventeurs:
- **GERGAUD, Patrice**
  **38054 GRENOBLE CEDEX 9 (FR)**
- **RECHE, Jérôme**
  **38054 GRENOBLE CEDEX 9 (FR)**
- **BLANCQUAERT, Yoann**
  **38054 GRENOBLE CEDEX 9 (FR)**
- **ALRIFAI, Liliane**
  **38054 GRENOBLE CEDEX 9 (FR)**

(74) Mandataire: **Lavoix**
**2, place d'Estienne d'Orves**
**75441 Paris Cedex 09 (FR)**

(56) Documents cités:
**FR-A1- 3 077 139    US-B2- 9 885 962**

- **STEPHEN KNIGHT ET AL: "Semiconductor microelectronics and nanoelectronics programs NIST IR 7426", 31 December 2007 (2007-12-31), pages 1 - 254, XP061055453, Retrieved from the Internet <URL:https://nvlpubs.nist.gov/nistpubs/Legacy/IR/nistir7426.pdf> [retrieved on 20071231], DOI: 10.6028/NIST.IR.7426**
- **RECHE JEROME ET AL: "Dimensional Control of Line Gratings by Small Angle X-Ray Scattering: Shape and Roughness Extraction", 2020 31ST ANNUAL SEMI ADVANCED SEMICONDUCTOR MANUFACTURING CONFERENCE (ASMC), IEEE, 24 August 2020 (2020-08-24), pages 1 - 6, XP033819728, DOI: 10.1109/ASMC49169.2020.9185351**

**Description**

La présente invention concerne un procédé de mesure d'une erreur dans la superposition de deux réseaux de lignes au cours de la fabrication d'un composant microélectronique.

La présente invention concerne plus particulièrement un procédé de mesure mettant en oeuvre une technique de diffusion des rayons X aux petits angles par transmission, ou T-SAXS (selon l'anglais « Transmission Small Angle X-ray Scattering »).

La fabrication d'un composant microélectronique nécessite que les différents niveaux le constituant soient superposés avec précision, de manière à ce que les motifs portés par ces différents niveaux soient correctement positionnés les uns par rapport aux autres afin de garantir le bon fonctionnement du composant final.

Il est connu de contrôler la précision de la superposition de deux niveaux en mesurant une erreur d'alignement, ou « overlay » (en reprenant abusivement le terme anglais comme le ferait l'homme du métier), entre un premier réseau de lignes prévu sur le premier niveau et un second réseau de lignes prévu sur le second niveau.

Pour mesurer cet overlay, le document US 9 885 962 B2 présente un procédé mettant en oeuvre une technique T-SAXS. Il s'agit d'éclairer les premier et second réseaux de lignes superposés l'un sur l'autre avec un faisceau de rayons X et d'évaluer l'overlay à partir des figures de diffraction obtenues par transmission pour différents angles d'incidence du faisceau de rayons X.

Plus précisément, pour un angle d'incidence donné, la figure de diffraction de la superposition des premier et second réseaux de lignes présente une succession de maximums, ou pic de Bragg. Chaque pic de Bragg est identifié par un entier n, dénommé ordre de Bragg.

Le procédé de mesure de l'overlay consiste, par mesures successives, à reconstruire une courbe donnant l'intensité du pic de Bragg d'ordre n pour différente valeurs de l'angle d'incidence, ainsi qu'une courbe donnant l'intensité du pic de Bragg d'ordre n' pour différentes valeurs de l'angle d'incidence.

Le procédé de mesure de l'overlay se poursuit en déterminant la position d'un minimum d'intensité sur la courbe associée à l'ordre de Bragg n, ainsi que la position du minimum d'intensité correspondant sur la courbe associée à l'ordre de Bragg n'.

Enfin, le procédé de mesure de l'overlay prévoir le calcul du rapport de la différence entre les positions des minimums correspondants entre les ordres de Bragg n et n' et la différence entre la position des pics de Bragg n et n'. Selon le document US 9 885 962 B2, cette différence n'est autre que l'overlay recherché.

Cependant, cette dernière assertion n'est pas exacte puisqu'il est nécessaire de connaître également l'espacement entre les premier et second réseaux de lignes pour, à partir du rapport, déterminer l'overlay. Or cet espacement qui peut différer de manière importante entre sa valeur théorique et sa valeur réelle, influence la valeur finale mesurée de l'overlay. Il est donc nécessaire que le procédé de mesure de l'overlay prévoit également la mesure de l'espacement réel entre les premiers et second réseaux de lignes.

Outre ce problème, ce procédé de l'état de la technique reste difficile à mettre en oeuvre sur une chaîne de fabrication de composants microélectroniques, car il nécessite non seulement la mesure de l'intensité pour différents angles d'incidence, mais surtout la répétition de ces mesures pour plusieurs pics de Bragg différents, afin de reconstruire autant de courbes d'intensité et pouvoir ensuite les comparer deux à deux.

Si ce procédé peut éventuellement être mis en oeuvre lorsque le composant en cours de fabrication ne comporte qu'un petit nombre de zones d'évaluation de l'overlay (zones portant les réseaux de lignes afin de mesurer l'overlay), il devient particulièrement difficile à mettre en oeuvre lorsque le composant en cours de fabrication comporte un grand nombre de zones d'évaluation de l'overlay. Or ceci devient la norme, par exemple pour la fabrication de « galettes » de silicium (« wafer » en anglais) pour laquelle il est nécessaire d'assurer une parfaite superposition des motifs en tous points de la galette, ce qui est contrôlé en multipliant les zones de mesure de l'overlay.

Le procédé présenté dans le document US 9 885 962 B2 n'est donc pas pratique.

Le but de la présente invention est de proposer un procédé particulièrement simple de mesure de l'overlay par T-SAXS.

Pour cela l'invention a pour objet un procédé de mesure d'un écart d'alignement entre un premier réseau de lignes porté par un premier niveau d'un composant microélectronique et un second réseau de lignes porté par un second niveau du composant microélectronique, un repère orthonormé xyz étant associé au composant microélectronique, les lignes des premier et second réseaux de lignes étant orientées selon la direction y, les premier et second réseaux de lignes étant superposés l'un sur l'autre selon la direction z, et l'écart d'alignement étant mesuré selon la direction x, le procédé de mesure mettant en oeuvre une technique de diffusion des rayons X par transmission T-SAXS, caractérisé en ce que le procédé comporte les étape de : acquérir à partir du composant microélectronique une pluralité de mesures d'intensité d'un faisceau de rayons X transmis pour une pluralité d'angles d'incidence du faisceau de rayons X, l'angle d'incidence étant défini comme l'angle, évalué dans le plan défini par les directions x et z, entre la direction z et la direction d'incidence du faisceau de rayons X ; reconstruire, à partir de la pluralité de mesures d'intensité, une figure de diffraction selon des fréquences spatiales $Q_x$ et $Q_z$, associées respectivement aux directions x et z ; déterminer, sur la figure de diffraction, une position selon la fréquence spatiale $Q_x$ d'une tige de Bragg d'intérêt et les positions selon la fréquence spatiale $Q_z$ de chaque point d'une paire de points caractéristiques de la tige de Bragg d'intérêt ; et, calculer l'écart d'alignement à partir des positions déterminées.

Suivant des modes particuliers de réalisation, le procédé comporte une ou plusieurs des caractéristiques suivantes, prises isolément ou suivant toutes les combinaisons techniquement possibles :

- la paire de points caractéristiques de la tige de Bragg d'intérêt est constituée du minimum d'indice i et du minimum correspondant d'indice -i de la tige de Bragg d'intérêt, i étant un entier supérieur ou égal à l'unité.
- l'écart d'alignement OVL est calculé en utilisant la relation :

$$OVL = \frac{(1+2(i-1))(Q_z^{n,i}+Q_z^{n,-i})}{Q_x^n.(Q_z^{n,i}-Q_z^{n,-i})},$$

où n est l'ordre de Bragg de la tige de Bragg d'intérêt, i est l'indice de la paire de minimums pris en compte, $Q_x^n$ est la position selon la fréquence spatiale $Q_x$ de la tige de Bragg d'intérêt, $Q_z^{n,i}$ est la position selon la fréquence spatiale $Q_z$ du minimum d'indice i et $Q_z^{n,-i}$ est la position selon la fréquence spatiale $Q_z$ du minimum correspondant d'indice -i.
- déterminer une position selon la fréquence spatiale $Q_x$ de la tige de Bragg d'intérêt comporte la détermination des positions selon la fréquence spatiale $Q_z$ de chaque point d'une autre paire de points caractéristiques de la tige de Bragg d'intérêt à partir de la figure de diffraction.
- ladite autre paire de points caractéristiques est constituée du minimum d'indice j et du minimum correspondant d'indice j de la tige de Bragg d'intérêt, l'indice j étant différent de l'indice i.
- la paire de points caractéristiques de la tige de Bragg d'intérêt est constituée du maximum d'indice i et du maximum correspondant d'indice -i de la tige de Bragg d'intérêt.
- l'étape de déterminer, sur la figure de diffraction, une position selon la fréquence spatiale $Q_x$ d'une tige de Bragg d'intérêt et les positions selon la fréquence spatiale $Q_z$ de chaque point d'une paire de points caractéristiques de la tige de Bragg d'intérêt est itérée pour une autre paire de points caractéristiques de la tige de Bragg d'intérêt et/ou pour une autre tige de Bragg d'intérêt, l'écart d'alignement résultant de la moyenne des écarts d'alignement calculés pour chaque itération.

L'invention a également pour objet un système instrumental du type T-SAXS, comportant un détecteur, une électronique d'acquisition et un calculateur, caractérisé en ce que le calculateur est convenablement programmé pour que ledit système instrumental mette en oeuvre un procédé de mesure d'un écart d'alignement selon le procédé précédent.

De préférence, le système comporte un détecteur adapté pour mesurer l'intensité du faisceau transmis sur une plage d'angle de diffraction réduite permettant de suivre la tige de Bragg d'intérêt au cours de l'étape d'acquisition.

L'invention a également pour objet un produit programme d'ordinateur comportant des instructions logicielles qui, lorsqu'elles sont exécutées par un calculateur du système instrumental précédent permettent à ce dernier de mettre en oeuvre un procédé conforme au procédé précédent.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :

[Fig 1] La figure 1 est une représentation schématique d'un système instrumental de mesure de l'overlay par T-SAXS ;
[Fig 2] La figure 2 est une représentation de la transformée de Fourier d'un motif pour lequel l'overlay est nul ;
[Fig 3] La figure 3 est une représentation de la transformée de Fourier d'un motif pour lequel l'overlay est non nul ;
[Fig 4] La figure 4 est une représentation sous forme de blocs d'un mode de réalisation du procédé de mesure de l'overlay selon l'invention ;
[Fig 5] La figure 5 est un graphe représentant l'intensité en fonction de l'angle de diffraction pour différentes valeurs de l'angle d'incidence pour un échantillon avec un seul réseau de lignes, c'est-à-dire sans overlay mais permettant d'illustrer la technique ;
[Fig 6] La figure 6 est la transformée de Fourier reconstruite à partir des mesures de la figure 5 ; et,

[Fig 7] La figure 7 est un agrandissement de la figure 3 au voisinage du pic de Bragg d'ordre 1 sur lequel des mesures de positions sont effectuées à partir desquelles déterminer l'overlay.

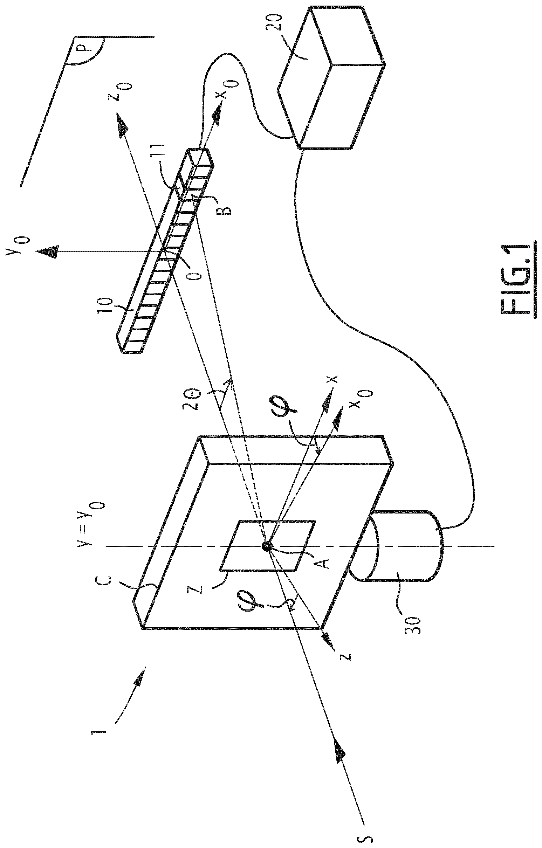

La figure 1 représente un système instrumental 1 de mesure de l'overlay.

Une source S de rayon X émet un faisceau de rayon X selon une direction $z_0$, perpendiculairement à un plan d'observation P. Le faisceau incident tombe en un point origine O du plan d'observation P. Des directions $x_0$ et $y_0$ définissent un repère orthonormal du plan P.

Un composant microélectronique C est interposé entre la source S et le plan d'observation P.

Le composant C est muni d'une zone Z de détermination de l'overlay.

Le centre A de la surface de la zone Z est placé sur l'axe d'incidence du faisceau de rayons X.

Un repère orthonormal xyz est associé au composant C. Ce repère est attaché au centre A de la surface de la zone Z de sorte que la direction y corresponde à la direction $y_0$, et que la direction z soit normale à la surface de la zone Z.

Comme précisé ci-après, les lignes du ou des réseaux de lignes permettant de mesurer l'overlay sont disposées parallèlement à l'axe $y_0$, de façon à avoir des pics de Bragg selon l'axe $x_0$.

Le composant C est placé sur un support 30 permettant de faire tourner le composant C autour de la direction y de manière à modifier l'angle $\varphi$ d'incidence du faisceau de rayons X sur la zone Z, c'est-à-dire l'angle entre la direction z et la direction $z_0$, qui est également l'angle entre la direction x et la direction $x_0$.

Un détecteur 10 est placé dans le plan d'observation P. Il est par exemple composé d'une barrette de capteurs disposés selon la direction x0.

L'intensité au point B de l'axe $x_0$, mesurée par le capteur localisé au point B, dépend de l'angle $2\theta$ entre la direction AO et la direction AB. Cette intensité est notée $I(\theta)$.

Comme connu en soi, l'image dans le plan d'observation P est en relation avec la transformée de Fourier spatiale de la zone Z éclairée par le faisceau incident.

Dans l'espace réciproque, la coordonnée associée à la direction $x_0$ est la fréquence spatiale $Q_0$ définie par :

$$Q_0 = \frac{2\sin(\theta)}{\lambda} \qquad\qquad (1)$$

Soit, toujours dans l'espace réciproque, mais en considérant les fréquences spatiales Qx et Qz respectivement associées aux directions x et z du repère lié au composant C (et par conséquent à la zone Z) :

$$Q_x = Q_0 \cos(\varphi) \qquad\qquad (2)$$

$$Q_z = Q_0 \sin(\varphi) \qquad\qquad (3)$$

Le détecteur 10 est connecté à un dispositif électronique, représenté de manière schématique sur la figure 1 par un cube portant la référence 20.

Le dispositif 20 comporte une électronique de contrôle permettant de commander le support 30 pour qu'il positionne le composant C selon une valeur de consigne de l'angle d'incidence.

Le dispositif 20 comporte également une électronique d'acquisition permettant d'effectuer des prétraitements adaptés sur les signaux délivrés par chacun des capteurs du détecteur 10 et à les numériser.

Le dispositif 10 comporte en outre un calculateur pour le traitement des signaux prétraités et numérisés. Le calculateur est un ordinateur comportant des moyens de calcul, tels qu'un processeur, et des moyens de mémorisation, tels qu'une mémoire. La mémoire stocke notamment les instructions de programmes d'ordinateur, en particulier un programme dont l'exécution permet la mise en oeuvre du procédé de mesure de l'overlay selon l'invention.

D'un point de vue théorique, il est possible de calculer exactement la transformée de Fourier spatiale d'un motif.

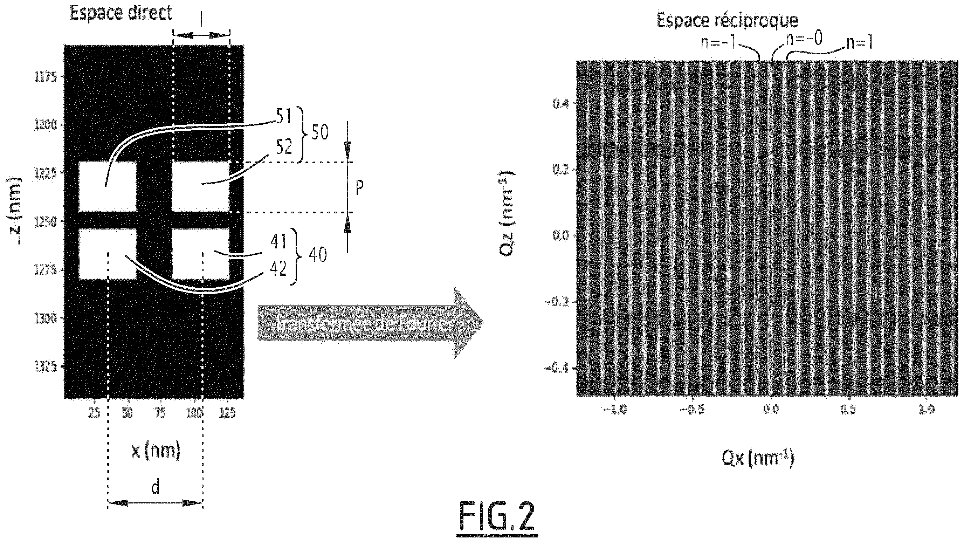

Ainsi, la partie de gauche de la figure 2 représente, dans l'espace direct des coordonnées x et z, une fraction du motif porté par la zone Z du composant C. Il s'agit de la superposition, dans l'épaisseur du circuit (c'est-à-dire selon la direction z), d'un premier réseau de lignes 40 et d'un second réseau de lignes 50. Par exemple, deux lignes 41 et 42 du premier réseau et deux lignes 51 et 52 du second réseau sont représentées. Les lignes de chacun de ces réseaux s'étendent selon la direction y.

Une ligne présente une section sensiblement rectangulaire dans le plan xy, de largeur l et de profondeur p. Deux lignes d'un réseau sont espacées d'un pas d.

Les deux réseaux de lignes 40 et 50 sont séparés l'un de l'autre d'une distance D.

Sur la figure 2, les premier et second réseaux de lignes sont parfaitement superposés selon la direction x.

Le calcul exact de la transformée de Fourier spatiale de ce motif conduit à la figure représentée sur la partie droite de la figure 2. Il s'agit donc d'une représentation dans l'espace réciproque des fréquences spatiales Qx et Qz, respectivement conjuguées des coordonnées x et z.

Pour une valeur nulle de $Q_z$, la transformée de Fourier présente, selon la direction $Q_x$, une succession de maximums, ou pic de Bragg. Chaque pic de Bragg est identifié par un entier n, dénommé ordre de Bragg. Le pic de Bragg d'ordre n est positionné en $Q_x^n$.

Pour un pic de Bragg donné, c'est-à-dire un $Q_x$ donné, l'intensité selon la direction $Q_z$ constitue ce que l'on dénomme la tige de Bragg d'ordre n. Quel que soit n, la tige de Bragg d'ordre n présente une alternance de maximums et de minimums locaux. La tige de Bragg d'ordre n est symétrique par rapport à l'axe $Q_x$ (à $Q_z = 0$). Ainsi, le $i^{\text{ème}}$ minimum de la tige de Bragg d'ordre n, situé en $Q_z^{n,i}$ ( $Q_z^{n,i}$ positif), correspond un $i^{\text{ème}}$ minimum de la tige de Bragg d'ordre n situé en $Q_z^{n,-i} = -Q_z^{n,i}$.

On constate que, lorsqu'il n'y a pas d'overlay, la position selon l'axe $Q_z$ du $i^{\text{ème}}$ minimum de la tige de Bragg est constante, quel que soit l'ordre de Bragg n considéré ( $Q_z^{n,i} = Q_z^i$ ).

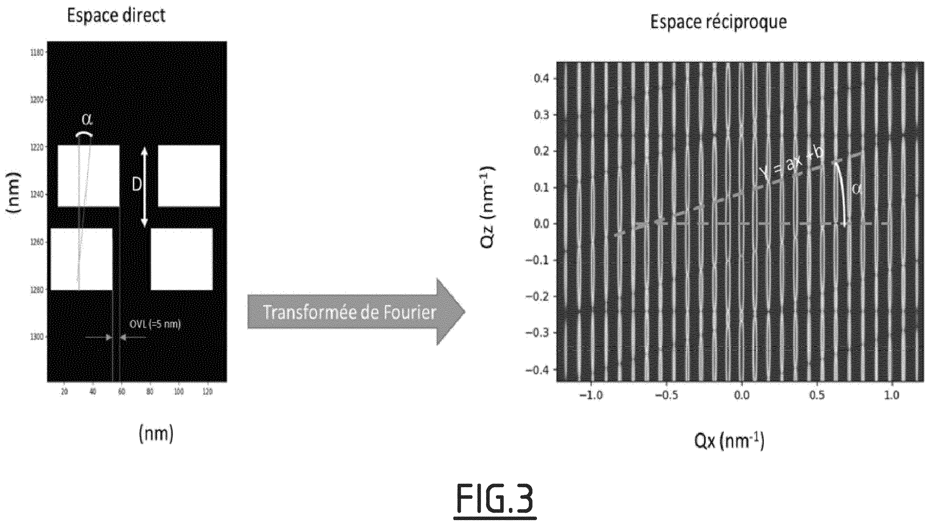

La figure 3 est similaire à la figure 2 à l'exception du fait que les premier et second réseaux de lignes 40 et 50 sont maintenant légèrement décalés l'un par rapport à l'autre selon la direction x d'un overlay OVL. Les lignes du second réseau 50 sont décalées angulairement par rapport aux lignes du premier réseau 40 d'un angle $a$ tel que :

$$tg(\alpha) = \frac{OVL}{D}$$

Soit, en première approximation, pour des valeurs de $\alpha$ petites :

$$\alpha = \frac{OVL}{D} \tag{4}$$

Le calcul exact de la transformée de Fourier spatiale de ce motif avec overlay conduit à la figure représentée sur la partie droite de la figure 3. Il s'agit d'une représentation dans l'espace réciproque des fréquences spatiales $Q_x$ et $Q_z$, respectivement conjuguées des coordonnées x et z.

On constate maintenant que les tiges de Bragg sont essentiellement translatées selon la direction $Q_z$ d'une quantité proportionnelle à $Qx$, à une constante près.

Ceci est particulièrement visible lorsque l'on suit le premier minimum positif de chaque tige de Bragg lorsque l'ordre de Bragg augmente ou lorsque l'on suit le premier minimum négatif de la chaque tige de Bragg lorsque l'ordre de Bragg augmente.

On peut ainsi écrire, pour le premier minimum positif de la tige de Bragg d'ordre n :

$$Q_z^{n,1} = \alpha Q_x^n + b$$

On peut écrire, pour le premier minimum négatif de la tige de Bragg d'ordre n :

$$Q_z^{n,-1} = \alpha Q_x^n - b$$

Par conséquent, pour une même tige de Bragg d'ordre n, la somme des positions des premiers minimums permet d'obtenir $\alpha$ :

$$Q_z^{n,1} + Q_z^{n,-1} = 2\alpha Q_x^n$$

Soit :

$$\alpha = (Q_z^{n,1} + Q_z^{n,-1})/2Q_x^n$$

Par ailleurs, sachant que la constante $b$ (valeur de la position selon la direction $Q_z$ du premier minimum positif de la tige de Bragg centrale, n=0) n'est autre que l'inverse du paramètre d'espacement D (ceci résulte du calcul par transformation de Fourier), la différence des positions des premiers minimums permet de déterminer $b$.

En effet, on a :

$$Q_z^{n,1} - Q_z^{n,-1} = 2b$$

Et :

$$b = 1/D = (Q_z^{n,1} - Q_z^{n,-1})/2$$

L'overlay peut alors être déterminé à partir des valeurs de $\alpha$ et b :

$$OVL = D.\alpha = \frac{\alpha}{b} = \frac{(Q_z^{n,1} + Q_z^{n,-1})}{Q_x^n.(Q_z^{n,1} - Q_z^{n,-1})} \qquad (6)$$

De manière plus générale, si l'on considère la paire de minimums constituée du $i^{ème}$ minimum positif et du $i^{ème}$ minimum négatif, les équations précédentes deviennent :

$$Q_z^{n,i} = \alpha Q_x^n + b.(1 + 2(i - 1))$$

$$Q_z^{n,-i} = \alpha Q_x^n - b.(1 + 2(i - 1))$$

Soit $\alpha$ :

$$\alpha = (Q_z^{n,i} + Q_z^{n,-i})/2Q_x^n$$

et b :

$$b = 1/D = (Q_z^{n,i} - Q_z^{n,-i})/2(1 + 2(i - 1))$$

Et par conséquent l'overlay :

$$OVL = D.\alpha = \frac{\alpha}{b} = \frac{(1 + 2(i-1))(Q_z^{n,i} + Q_z^{n,-i})}{Q_x^n.(Q_z^{n,i} - Q_z^{n,-i})} \qquad (7)$$

De manière plus générale encore, on pourrait écrire des relations équivalentes pour une paire de minima qui serait constituée du $i^{ème}$ minimum (positif ou négatif) et du $j^{ème}$ minimum (positif ou négatif).

Des relations équivalentes peuvent également être déterminées pour d'autres points caractéristiques de la tige de Bragg d'ordre n, notamment les maximums d'intensité de cette tige.

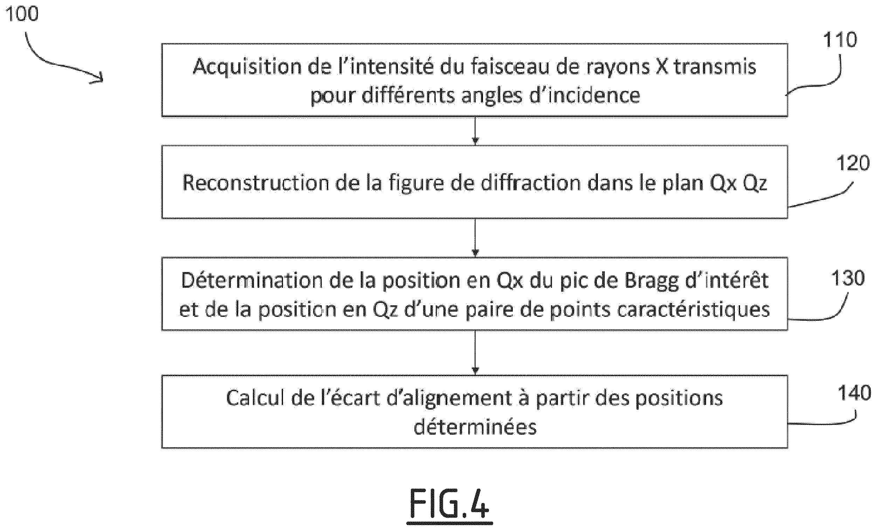

Compte tenu de ces considérations théoriques, un mode de réalisation du procédé de mesure de l'overlay selon l'invention va maintenant être présenté en référence à la figure 4.

Le procédé 100 consiste d'abord à reconstruire au moins la tige de Bragg d'ordre n considérée comme la tige d'intérêt.

Pour cela, dans une première étape 110 d'acquisition, au moyen du détecteur 10, on itère la mesure de l'intensité pour différents angles d'incidence φ. Par exemple, on fait varier l'angle d'incidence par pas de 1° dans la plage de +60° à -60° et pour chaque valeur de l'angle d'incidence on mesure l'intensité $I(\theta)$ en fonction de la position le long de l'axe

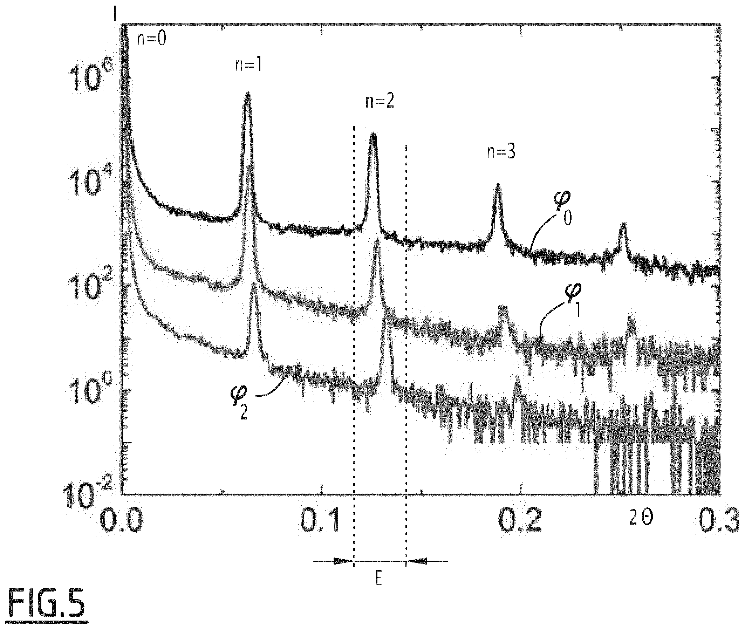

$x_0$ du plan d'observation P, c'est-à-dire en fonction de l'angle de diffraction $\theta$. On obtient ainsi une pluralité de courbes d'intensité, telles que celles représentées sur la figure 5 pour trois valeurs différentes de l'angle d'incidence.

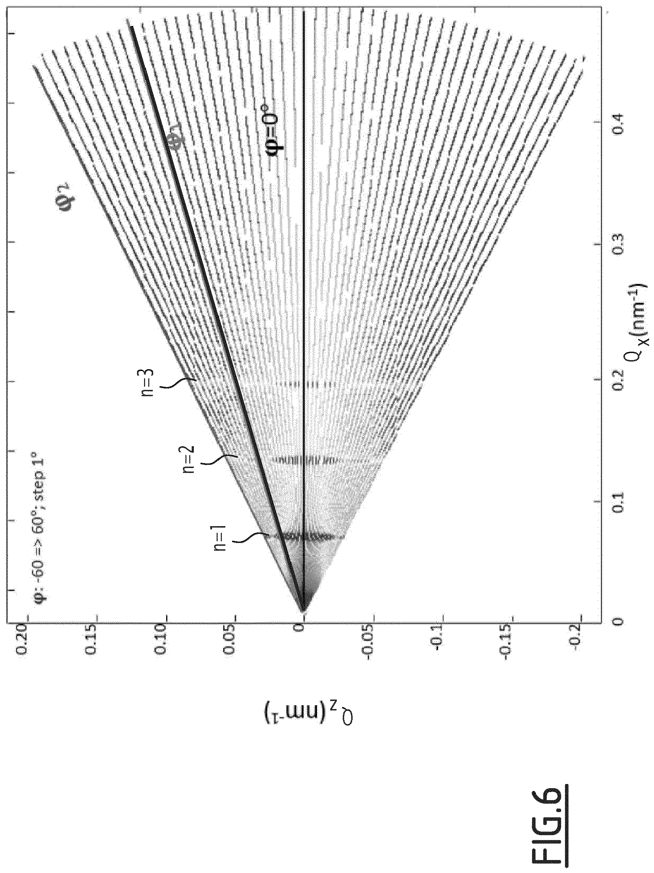

Le procédé 100 se poursuit par une seconde étape 120 consistant à reconstruire la figure de diffraction dans l'espace réciproque décrit par les coordonnées $Q_x$ et $Q_z$. On utilise la pluralité de courbes d'intensité obtenues à l'étape 110 et les relations (1) (2) et (3) ci-dessus pour obtenir par exemple la figure de la figure 6.

Une fois la tige de Bragg d'intérêt reconstruite, le procédé 100 se poursuit par une étape 130 de détermination de la position selon l'axe $Q_x$ de la tige de Bragg d'intérêt et de la position selon l'axe $Q_z$ d'une paire de points caractéristiques de la tige de Bragg d'intérêt.

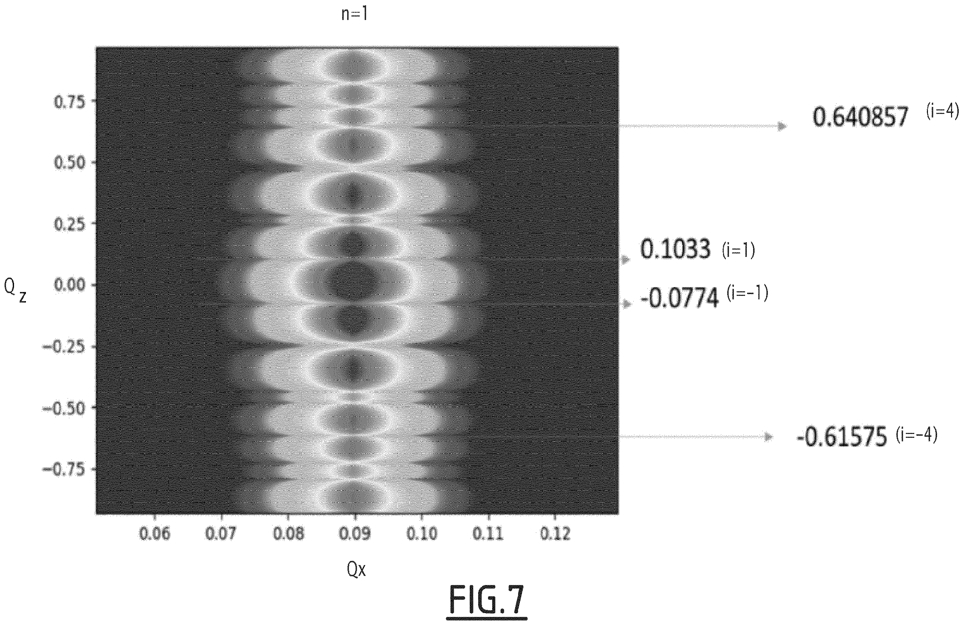

Par exemple, sur la figure 7, qui est une représentation agrandie de la figure 3 autour de la tige de Bragg d'ordre 1 en tant que tige de Bragg d'intérêt, on mesure la position $Q_x^1$ et les positions $Q_z^{1,1}$ du premier minimum positif et $Q_z^{1,-1}$ du premier minimum négatif le long de cette tige de Bragg. On obtient selon l'exemple de la figure 7 :

$$Q_x^1 = 0.09$$

$$Q_z^{1,1} = 0.1033$$

$$Q_z^{1,-1} = -0.0774$$

En variante, on pourrait mesurer la position des i$^{\text{ème}}$ minimums positif et négatif de la tige de Bragg d'intérêt. Par exemple, pour i=4 sur la première tige de Bragg, on obtient sur la figure 7 :

$$Q_z^{1,4} = 0.640857$$

$$Q_z^{1,-4} = -0.61575$$

Enfin, dans une quatrième étape 140, on injecte les mesures des positions des minima dans la relation (6) (ou la relation (7) pour un minimum d'indice i supérieur à l'unité) pour calculer la valeur de l'overlay OVL de la zone Z du composant C analysée.

Par exemple, sur la paire de premiers minimums, la valeur de overlay dans l'exemple de la figure 7 est de 5nm.

Le système instrumental 1 est adapté pour mettre en oeuvre le procédé de mesure 100 venant d'être présenté. En particulier, le calculateur du système 1 est convenablement programmé pour réaliser les étapes calculatoires, c'est-à-dire les étapes autres que l'étape d'acquisition.

D'autre modes de réalisation du procédé sont envisageables.

Ainsi, en variante, pour éviter d'avoir à mesurer la position de la tige de Bragg d'intérêt, $Q_x^n$, on pourrait combiner les mesures des positions d'une première paire de minimums (par exemple d'ordre 1) et celles d'une seconde paire de minimums (par exemple d'ordre 4) de la tige de Bragg d'intérêt.

Dans une autre variante, d'autres points caractéristiques d'une tige de Bragg peuvent être considérés : paire composée de minimums d'indice différents (que ces indices soient positif(s) et/ou négatif(s)), paire composée de maximums d'indices identiques ou différents (que ces indices soient positif(s) et/ou négatif(s), paire composée d'un maximum et d'un minimum d'indices identiques ou différents (que ces indices soient positif(s) et/ou négatif(s)), etc. C'est-à-dire, de manière générale, toute corrélation de points de la tige de Bragg résultant de la translation de celle-ci à cause de la présence d'un overlay.

Pour augmenter la précision de la mesure de l'overlay, le procédé peut être répété pour d'autres paires de points caractéristique de la tige de Bragg d'intérêt (d'ordre n) et/ou d'une autre tige de Bragg d'intérêt (d'ordre n' différent de n). Les différentes mesures de l'overlay sont ensuite moyennées pour obtenir une valeur finale plus précise.

Il est à noter que plus l'indice n du pic de Bragg d'intérêt est faible, plus le contraste est important, ce qui améliore la détermination de la position d'un minimum local de l'intensité.

D'un autre côté, plus l'indice n du pic de Bragg d'intérêt est grand plus le déplacement du minimum due à l'overlay est important.

Il est donc nécessaire de faire un compromis : si le critère est le temps de mesure alors il vaut mieux travailler sur un pic de Bragg d'indice n faible ; en revanche, si le critère est la résolution de la mesure, alors il faut travailler sur un pic de Bragg d'indice n grand.

Ainsi, dans la pratique, le ou les tiges de Bragg d'intérêt sont sélectionnées avec un ordre entre 1 et 5, de préférence égal à 3.

De plus, plus la paire de points caractéristiques utilisée pour le calcul de l'overlay est proche de la valeur $Q_z$ = 0, plus la plage de variation de l'angle d'incidence peut être réduite. Par exemple, pour la paire de premiers minimums de la tige de Bragg d'intérêt, l'angle d'incidence peut varier sur une plage réduite, entre +10° et -10° par exemple. Ceci permet de réduire le temps nécessaire à la première étape du procédé associée à la collecte des mesures d'intensité pour différents angles d'incidence.

Avantageusement, puisqu'il s'agit au minimum de suivre une unique tige de Bragg, par exemple celle du pic de Bragg d'ordre n (c'est-à-dire de considérer une position $Q_x^n$ fixe), l'intensité peut être mesurée sur une plage angulaire en $2\theta$ réduite correspondant aux valeurs de l'angle de diffraction $\theta$ données par, lorsque $\varphi$ varie sur la plage d'incidence :

$$\theta = \mathrm{asin}[(\lambda Q_x^n)/(2\cos(\varphi))]$$

Si la plage d'incidence est réduite, la plage angulaire en $2\theta$ peut également être réduite. Avantageusement, la plage angulaire en $2\theta$ est réduite pour correspondre à l'ouverture d'un unique capteur.

Dans ce cas, le système instrumental peut être simplifié en utilisant un détecteur ne comportant qu'un petit nombre de capteurs, voir un unique capteur, convenablement positionné(s) dans le plan d'observation P pour pouvoir mesurer l'intensité d'un même pic de Bragg d'intérêt sur toute la plage de variation de l'angle d'incidence. Par exemple, sur la figure 5, en considérant le pic de Bragg d'ordre 2 comme le pic d'intérêt, il suffirait de disposer dans le plan d'observation P d'un unique capteur dont l'ouverture E couvrirait les angles $2\theta$ entre 0.115 et 0.135°.

Dans le mode de réalisation de la figure 1, c'est l'orientation du composant dans le faisceau de rayons X qui est modifiée pour faire varier l'angle d'incidence. En variante, le composant est fixe et c'est la source qui est déplacée pour faire varier l'angle d'incidence. Le déplacement de la source peut être réel ou virtuel en utilisant un système de lentilles adaptées.

## Revendications

1. Procédé (100) de mesure d'un écart d'alignement (OVL) entre un premier réseau de lignes (40) porté par un premier niveau d'un composant microélectronique (C) et un second réseau de lignes (50) porté par un second niveau du composant microélectronique, un repère orthonormé xyz étant associé au composant microélectronique, les lignes des premier et second réseaux de lignes étant orientées selon la direction y, les premier et second réseaux de lignes étant superposés l'un sur l'autre selon la direction z, et l'écart d'alignement (OVL) étant mesuré selon la direction x, le procédé de mesure mettant en oeuvre une technique de diffusion des rayons X aux petits angles par transmission (T-SAXS), le procédé comportant les étape de :

- acquérir à partir du composant microélectronique une pluralité de mesures d'intensité d'un faisceau de rayons X transmis pour une pluralité d'angles d'incidence du faisceau de rayons X, l'angle d'incidence étant défini comme l'angle, évalué dans le plan défini par les directions x et z, entre la direction z et la direction d'incidence du faisceau de rayons X ;
- reconstruire, à partir de la pluralité de mesures d'intensité, une figure de diffraction selon des fréquences spatiales $Q_x$ et $Q_z$, associées respectivement aux directions x et z ; **caractérisé en ce que** le procédé comporte les étapes de:

- déterminer, sur la figure de diffraction, une position selon la fréquence spatiale $Q_x$ d'une tige de Bragg d'intérêt et les positions selon la fréquence spatiale $Q_z$ de chaque point d'une paire de points caractéristiques de la tige de Bragg d'intérêt ; et,
- calculer l'écart d'alignement à partir des positions déterminées.

2. Procédé de mesure selon la revendication 1, dans lequel la paire de points caractéristiques de la tige de Bragg d'intérêt est constituée du minimum d'indice i et du minimum correspondant d'indice -i de la tige de Bragg d'intérêt, i étant un entier supérieur ou égal à l'unité.

3. Procédé de mesure selon la revendication 2, dans lequel l'écart d'alignement OVL est calculé en utilisant la relation :

$$OVL = \frac{(1+2(i-1))(Q_z^{n,i}+Q_z^{n,-i})}{Q_x^n.(Q_z^{n,i}-Q_z^{n,-i})},$$

où n est l'ordre de Bragg de la tige de Bragg d'intérêt, i est l'indice de la paire de minimums pris en compte, $Q_x^n$ est la position selon la fréquence spatiale $Q_x$ de la tige de Bragg d'intérêt, $Q_z^{n,i}$ est la position selon la fréquence spatiale $Q_z$ du minimum d'indice i et $Q_z^{n,-i}$ est la position selon la fréquence spatiale $Q_z$ du minimum correspondant d'indice -i.

4. Procédé de mesure selon la revendication 3, dans lequel déterminer une position selon la fréquence spatiale $Q_x$ de la tige de Bragg d'intérêt comporte la détermination des positions selon la fréquence spatiale $Q_z$ de chaque point d'une autre paire de points caractéristiques de la tige de Bragg d'intérêt à partir de la figure de diffraction.

5. Procédé de mesure selon la revendication 4, dans lequel ladite autre paire de points caractéristiques est constituée du minimum d'indice j et du minimum correspondant d'indice j de la tige de Bragg d'intérêt, l'indice j étant différent de l'indice i.

6. Procédé de mesure selon la revendication 1, dans lequel la paire de points caractéristiques de la tige de Bragg d'intérêt est constituée du maximum d'indice i et du maximum correspondant d'indice -i de la tige de Bragg d'intérêt.

7. Procédé de mesure selon l'une quelconque des revendications précédentes, dans lequel l'étape de déterminer, sur la figure de diffraction, une position selon la fréquence spatiale $Q_x$ d'une tige de Bragg d'intérêt et les positions selon la fréquence spatiale $Q_z$ de chaque point d'une paire de points caractéristiques de la tige de Bragg d'intérêt est itérée pour une autre paire de points caractéristiques de la tige de Bragg d'intérêt et/ou pour une autre tige de Bragg d'intérêt, l'écart d'alignement résultant de la moyenne des écarts d'alignement calculés pour chaque itération.

8. Système instrumental (1) du type par diffusion des rayons X aux petits angles par transmission (T-SAXS), comportant un détecteur, une électronique d'acquisition et un calculateur, **caractérisé en ce que** le calculateur est convenablement programmé pour que ledit système instrumental mette en oeuvre un procédé de mesure d'un écart d'alignement selon l'une quelconque des revendications 1 à 7.

9. Système instrumental selon la revendication 8, comportant un détecteur adapté pour mesurer l'intensité du faisceau transmis sur une plage d'angle de diffraction réduite permettant de suivre la tige de Bragg d'intérêt au cours de l'étape d'acquisition.

10. Produit programme d'ordinateur comportant des instructions logicielles qui, lorsqu'elles sont exécutées par un calculateur d'un système instrumental conforme à l'une quelconque des revendication 8 et 9 permet à ce dernier de mettre en oeuvre un procédé selon l'une quelconque des revendications 1 à 7.

**Patentansprüche**

1. Verfahren (100) zum Messen einer Ausrichtungsabweichung (OVL) zwischen einem ersten Leitungsnetz (40), das von einer ersten Ebene einer mikroelektronischen Komponente (C) getragen wird, und einem zweiten Leitungsnetz (50), das von einer zweiten Ebene der mikroelektronischen Komponente getragen wird, wobei ein orthonormales xyz-Koordinatensystem mit der mikroelektronischen Komponente assoziiert ist, die Linien des ersten und des zweiten Liniennetzes in der y-Richtung ausgerichtet sind, das erste und das zweite Liniennetz in der z-Richtung übereinander liegen und die Ausrichtungsabweichung (OVL) in der x-Richtung gemessen wird, wobei das Messverfahren eine Technik von Kleinwinkel-Röntgenstreuung durch Transmission (T-SAXS) einsetzt, das Verfahren umfassend die folgenden Schritte:

- Erfassen, von der mikroelektronischen Komponente, einer Vielzahl von Intensitätsmessungen eines übertragenen Röntgenstrahls für eine Vielzahl von Einfallswinkeln des Röntgenstrahls, wobei der Einfallswinkel als der in der durch die x- und z-Richtung definierten Ebene bewertete Winkel zwischen der z-Richtung und der Einfallsrichtung des Röntgenstrahls definiert ist;
- Rekonstruieren, aus der Vielzahl von Intensitätsmessungen, eines Beugungsmusters gemäß den Raumfrequenzen $Q_x$ und $Q_z$, die jeweils mit der x- und der z-Richtung assoziiert sind;

**dadurch gekennzeichnet, dass** das Verfahren die folgenden Schritte umfasst:

- Bestimmen, auf der Beugungsfigur, einer Position gemäß der Raumfrequenz $Q_x$ eines Bragg-Stabs von Interesse, und der Positionen gemäß der Raumfrequenz $Q_z$ von jedem Punkt eines Paars von charakteristischen Punkten des Bragg-Stabs von Interesse; und
- Berechnen der Ausrichtungsabweichung anhand der bestimmten Positionen.

2. Messverfahren nach Anspruch 1, wobei das Paar von charakteristischen Punkten des Bragg-Stabs von Interesse aus dem Minimum mit Index i und dem entsprechenden Minimum mit Index-i des Bragg-Stabs von Interesse besteht, wobei i eine ganze Zahl größer als oder gleich wie eins ist.

3. Messverfahren nach Anspruch 2, wobei die Ausrichtungsabweichung OVL unter Verwendung der folgenden Beziehung berechnet wird:

$$OVL = \frac{(1 + 2(i-1))\left(Q_z^{n,i} + Q_z^{n,-i}\right)}{Q_x^n \cdot \left(Q_z^{n,i} - Q_z^{n,-i}\right)}$$

wobei n die Bragg-Ordnung des Bragg-Stabs von Interesse ist, i der Index des Paars von berücksichtigten Minima ist, $Q_x^n$ die Position gemäß der Raumfrequenz $Q_x$ des Bragg-Stabs von Interesse ist, $Q_z^{n,i}$ die Position gemäß der Raumfrequenz $Q_z$ des Minimums mit Index i ist und $Q_z^{n,-i}$ die Position gemäß der Raumfrequenz $Q_z$ des entsprechenden Minimums mit Index -i ist.

4. Messverfahren nach Anspruch 3, wobei das Bestimmen einer Position gemäß der Raumfrequenz $Q_x$ des Bragg-Stabs von Interesse das Bestimmen der Positionen gemäß der Raumfrequenz $Q_z$ von jedem Punkt eines anderen Paars von charakteristischen Punkten des Bragg-Stabs von Interesse aus der Beugungsfigur umfasst.

5. Messverfahren nach Anspruch 4, wobei das andere Paar von charakteristischen Punkten aus dem Minimum mit Index j und dem entsprechenden Minimum mit Index -j des Bragg-Stabs von Interesse besteht, wobei der Index j von dem Index i verschieden ist.

6. Messverfahren nach Anspruch 1, wobei das Paar von charakteristischen Punkten des Bragg-Stabs von Interesse aus dem Maximum mit Index i und dem entsprechenden Maximum mit Index -i des Bragg-Stabs von Interesse besteht.

7. Messverfahren nach einem der vorherigen Ansprüche, wobei der Schritt eines Bestimmens, auf der Beugungsfigur, einer Position gemäß der Raumfrequenz $Q_x$ eines Bragg-Stabs von Interesse, und den Positionen gemäß der Raumfrequenz $Q_z$ von jedem Punkt eines Paars von charakteristischen Punkten des Bragg-Stabs von Interesse für ein anderes Paar von charakteristischen Punkten des Bragg-Stabs von Interesse und/oder für einen anderen Bragg-Stab von Interesse iteriert wird, wobei die Ausrichtungsabweichung aus dem Mittelwert der für jede Iteration berechneten Ausrichtungsabweichungen resultiert.

8. Instrumentensystem (1) vom Typ Kleinwinkel-Röntgenstreuung durch Transmission (T-SAXS), umfassend einen Detektor, eine Erfassungselektronik und einen Rechner, **dadurch gekennzeichnet, dass** der Rechner auf geeignete Weise programmiert ist, damit das Instrumensystem ein Verfahren zum Messen einer Ausrichtungsabweichung nach einem der Ansprüche 1 bis 7 durchführt.

9. Instrumentensystem nach Anspruch 8, umfassend einen Detektor, der angepasst ist, um die Intensität des übertragenen Strahls über einen reduzierten Beugungswinkelbereich zu messen, der es ermöglicht, den Bragg-Stab von Interesse während des Erfassungsschritts zu verfolgen.

10. Computerprogrammprodukt, umfassend Softwareanweisungen, die, wenn sie von einem Rechner eines Instrumentensystems nach einem der Ansprüche 8 und 9 ausgeführt werden, es diesem letzteren ermöglichen, ein Verfahren nach einem der Ansprüche 1 bis 7 auszuführen.

**Claims**

1. A method (100) for measuring a misalignment (OVL) between a first array of lines (40) carried by a first level of a microelectronic component (C) and a second array of lines (50) carried by a second level of the microelectronic component, an orthonormal coordinate system xyz being associated with the microelectronic component, the lines of the first and second arrays of lines being oriented in the y direction, the first and second arrays of lines being superimposed one on the other in the z direction, and the misalignment (OVL) being measured in the x direction, the measurement method implementing a technique of transmission small angle X-ray scattering (T-SAXS), the method comprising the steps of:

   - acquiring, from the microelectronic component, a plurality of intensity measurements of a transmitted X-ray beam for a plurality of incidence angles of the X-ray beam, the incidence angle being defined as the angle, evaluated in the plane defined by the x and z directions, between the z direction and the direction of incidence of the X-ray beam;
   - reconstructing, from the plurality of intensity measurements, a diffraction pattern according to spatial frequencies $Q_x$ and $Q_z$, associated respectively with the x and z directions; **characterized in that** the process comprises the steps of:

      - determining, on the diffraction pattern, a position according to the spatial frequency $Q_x$ of a Bragg rod of interest and the positions according to the spatial frequency $Q_z$ of each point of a pair of characteristic points of the Bragg rod of interest; and
      - calculating the misalignment from the determined positions.

2. The measuring method according to claim 1, wherein the pair of characteristic points of the Bragg rod of interest consists of the minimum of index i and the corresponding minimum of index -i of the Bragg rod of interest, i being an integer greater than or equal to unity.

3. The measuring method according to claim 2, wherein the misalignment OVL is calculated using the relationship:

$$OVL = \frac{(1 + 2(i-1))\left(Q_z^{n,i} + Q_z^{n,-i}\right)}{Q_x^n \cdot \left(Q_z^{n,i} - Q_z^{n,-i}\right)}$$

where n is the Bragg order of the Bragg rod of interest, i is the index of the pair of minima taken into account, $Q_x^n$ is the position according to the spatial frequency $Q_x$ of the Bragg rod of interest, $Q_z^{n,i}$ is the position according to the spatial frequency $Q_z$ of the minimum of index i and $Q_z^{n,-i}$ is the position according to the spatial frequency $Q_z$ of the corresponding minimum of index -i.

4. The measuring method according to claim 3, wherein determining a position according to the spatial frequency $Q_x$ of the Bragg rod of interest comprises determining the positions according to the spatial frequency $Q_z$ of each point of another pair of characteristic points of the Bragg rod of interest from the diffraction pattern.

5. The measuring method according to claim 4, wherein said other pair of characteristic points consists of the minimum of index j and the corresponding minimum of index -j of the Bragg rod of interest, the index j being different from the index i.

6. The measuring method according to claim 1, wherein the pair of characteristic points of the Bragg rod of interest consists of the maximum of index i and the corresponding maximum of index -i of the Bragg rod of interest.

7. The measuring method according to any one of the preceding claims, wherein the step of determining, on the diffraction pattern, a position according to the spatial frequency $Q_x$ of a Bragg rod of interest and the positions according to the spatial frequency $Q_z$ of each point of a pair of characteristic points of the Bragg rod of interest is iterated for another pair of characteristic points of the Bragg rod of interest and/or for another Bragg rod of interest, the misalignment resulting from the average of the misalignments calculated for each iteration.

8. An instrumental system (1) of the transmission small-angle X-ray scattering (T-SAXS) type, comprising a detector, acquisition electronics and a computer, **characterized in that** the computer is suitably programmed so that said instrumental system implements a method for measuring a misalignment according to any one of claims 1 to 7.

9. The instrumental system according to claim 8, comprising a detector adapted to measure the intensity of the beam transmitted over a reduced diffraction angle range making it possible to follow the Bragg rod of interest during the acquisition step.

10. A computer program product comprising software instructions which, when executed by a computer of an instrumental system conforming to any one of claims 8 and 9, allows the latter to implement a method according to any one of claims 1 to 7.

FIG.1

EP 4 246 135 B1

FIG.2

Espace direct

Transformée de Fourier

Espace réciproque

FIG.3

EP 4 246 135 B1

100

110
Acquisition de l'intensité du faisceau de rayons X transmis pour différents angles d'incidence

120
Reconstruction de la figure de diffraction dans le plan Qx Qz

130
Détermination de la position en Qx du pic de Bragg d'intérêt et de la position en Qz d'une paire de points caractéristiques

140
Calcul de l'écart d'alignement à partir des positions déterminées

## FIG.4

FIG.5

**FIG.6**

FIG.7

EP 4 246 135 B1

**EP 4 246 135 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9885962 B2